(19) Europäisches Patentamt / European Patent Office / Office européen des brevets

(11) **EP 3 389 098 A1**

(12) **EUROPEAN PATENT APPLICATION**
published in accordance with Art. 153(4) EPC

(43) Date of publication:
**17.10.2018 Bulletin 2018/42**

(51) Int Cl.:
***H01L 31/048*** (2014.01)

(21) Application number: **16872629.7**

(22) Date of filing: **08.12.2016**

(86) International application number:
**PCT/JP2016/005086**

(87) International publication number:
**WO 2017/098728 (15.06.2017 Gazette 2017/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **10.12.2015 JP 2015240766**

(71) Applicant: **Panasonic Intellectual Property Management Co., Ltd.**
**Osaka-shi, Osaka 540-6207 (JP)**

(72) Inventors:
• **UEDA, Takeshi**
  **Osaka-shi, Osaka 540-6207 (JP)**

• **KURIZOE, Naoki**
  **Osaka-shi, Osaka 540-6207 (JP)**
• **IKOMA, Yoshimitsu**
  **Osaka-shi, Osaka 540-6207 (JP)**
• **ANDO, Hideyuki**
  **Osaka-shi, Osaka 540-6207 (JP)**
• **YAMAZAKI, Keiichi**
  **Osaka-shi, Osaka 540-6207 (JP)**
• **SUGIYAMA, Motohiko**
  **Osaka-shi, Osaka 540-6207 (JP)**

(74) Representative: **Müller-Boré & Partner**
**Patentanwälte PartG mbB**
**Friedenheimer Brücke 21**
**80639 München (DE)**

(54) **SOLAR CELL MODULE**

(57) A solar cell module (100) includes a first resin substrate (20), a first resin layer (22) provided over the first resin substrate (20), a second resin layer (24) provided over the first resin layer (22), a photoelectric converter (10, 16) provided over the second resin layer (24), and a third resin layer (26) provided over the photoelectric converter (10, 16) and the second resin layer (24), wherein a tensile modulus of elasticity of the first resin layer (22) is smaller than a tensile modulus of elasticity of each of the resin substrate (20), the second resin layer (24), and the third resin layer (26).

FIG. 2

**Description**

TECHNICAL FIELD

The present invention relates to solar cell modules and, more particularly, to a solar cell module using a resin substrate.

BACKGROUND ART

Resin substrates are used in solar cell modules, instead of glass substrates, in order to achieve a reduction in weight. Since a coefficient of thermal expansion of a resin substrate is typically higher than that of a glass substrate, the amount of displacement of the resin substrate caused by thermal expansion or contraction is greater than that of the glass substrate. The thermal expansion or contraction of the resin substrate applies a load to tab leads or sealing members between solar cells and therefore may cause fatigue breakage of the tab leads. In view of this problem, gel and an ethylene-vinyl acetate copolymer (EVA) are sequentially applied onto the resin substrate, and the solar cells are interposed between the gel and the EVA (for example, refer to Patent Literature 1)

CITATION LIST

PATENT LITERATURE

Patent Literature 1: Japanese Patent Application Publication No. 2011-049485

SUMMARY OF INVENTION

The solar cell module needs not only to deal with thermal expansion but also to improve resistance to impact because hail or the like may fall onto the solar cell module. Although the gel absorbs flexure of the resin substrate caused by the impact of hail or the like to some extent, a load tends to be concentrated on the part of the flexure. When the gel and the solar cells are arranged in contact with each other, a local load is applied to the solar cells.
In view of the conventional problems, the present invention provides a solar cell module ensuring improved resistance to impact.

SOLUTION TO PROBLEM

In order to solve the problems described above, a solar cell module according to an aspect of the present invention includes: a resin substrate; a first resin layer provided over the resin substrate; a second resin layer provided over the first resin layer; a photoelectric converter provided over the second resin layer; and a third resin layer provided over the photoelectric converter and the second resin layer. A tensile modulus of elasticity of the first resin layer is smaller than a tensile modulus of elasticity of each of the resin substrate, the second resin layer, and the third resin layer.

BRIEF DESCRIPTION OF DRAWINGS

[FIG. 1] FIG. 1 is a top view showing a solar cell module according to Embodiment 1 of the present invention.
[FIG. 2] FIG. 2 is a cross-sectional view showing the solar cell module of FIG. 1.
[FIG. 3] FIG. 3 is a schematic view illustrating a load applied to the solar cell module of FIG. 2.
[FIG. 4] FIG. 4(a) to (b) are views showing a neutral axis in the solar cell module of FIG. 2.
[FIG. 5] FIG. 5 is a cross-sectional view showing a solar cell module according to Embodiment 2 of the present invention.
[FIG. 6] FIG. 6 is a cross-sectional view showing a solar cell module according to Embodiment 3 of the present invention.
[FIG. 7] FIG. 7 is a cross-sectional view showing a solar cell module according to Embodiment 4 of the present invention.
[FIG. 8] FIG. 8 is a cross-sectional view showing a solar cell module according to Embodiment 5 of the present invention.
[FIG. 9] FIG. 9 is a schematic view illustrating refraction of light at an interface between resin layers.
[FIG. 10] FIG. 10 is a view showing an external appearance of the respective solar cell modules of Examples 7 to 9.

[FIG. 11] FIG. 11 is a cross-sectional view showing a solar cell module according to Embodiment 7 of the present invention.

DESCRIPTION OF EMBODIMENTS

(Embodiment 1)

The outline of the present embodiment is described first before the specific explanations are made. Embodiment 1 relates to a solar cell module including a plurality of solar cells. The solar cell module needs to achieve a reduction in weight in order to be used for various purposes and is therefore provided with a resin substrate instead of a glass substrate. Hail or the like may fall on the solar cell module. Since the resin substrate has a smaller tensile modulus of elasticity than a glass substrate, a load due to the impact of hail or the like may be applied to the inside of the solar cell module to cause damage to the solar cells. Therefore, it is desirable to improve the resistance to impact in the solar cell module when the resin substrate is used.

When hail or the like hits the resin substrate, a load caused by the impact of the hail is applied to the resin substrate, and the resin substrate is bent about the hit part. When gel is applied between the resin substrate and the solar cells, the gel reduces the load applied from the resin substrate since the gel has a small tensile modulus of elasticity. However, since a greater load at the bent part of the resin substrate is applied to the gel, a local load from the gel is applied to the solar cells. It is preferable to disperse a load in order to prevent damage to the solar cells and tab leads provided between the solar cells adjacent to each other.

In view of the foregoing, the solar cell module according to Embodiment 1 includes a resin substrate, gel, a resin layer, and solar cells sequentially arranged. The tensile modulus of elasticity of the resin layer is greater than that of the gel. A local load from the gel is thus dispersed in the resin layer, so that a load dispersed in the resin layer is applied to the solar cells.

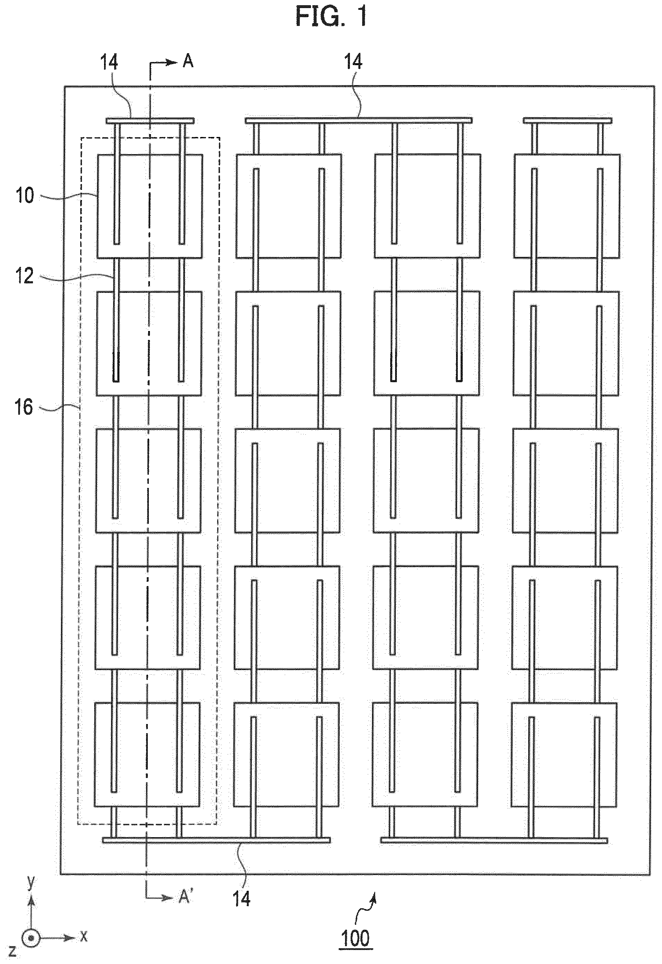

FIG. 1 is a top view showing the solar cell module 100 according to Embodiment 1. As shown in FIG. 1, a three-dimensional coordinate system is defined by x, y, and z axes. The x and y axes are perpendicular to each other in the plane of the solar cell module 100. The z axis is perpendicular to the x and y axes and extends in the thickness direction of the solar cell module 100. A positive direction of the respective x, y, and z axes conforms to a direction indicated by the respective arrows in FIG. 1, and a negative direction conforms to a direction opposite to the direction of the arrows. The solar cell module 100 is defined by two main surfaces parallel to the x-y plane, wherein one of the main surfaces located in the positive direction of the z axis is a "light receiving surface", and the other surface located in the negative direction of the z axis is a "rear surface". The term "light receiving surface" may refer to a surface on which light is mainly incident, and the term "rear surface" may refer to a surface opposite to the light receiving surface. The positive direction of the z axis is also referred to as the "light receiving surface side", and the negative direction of the z axis is also referred to as the "rear surface side".

The expression such as "a second member is provided over a first member" may refer to either a state in which the first member and the second member are in direct contact with each other or a state in which another member is interposed between the first member and the second member, unless otherwise specified. As used herein, the term "upper" may be either the positive direction of the z axis or the negative direction of the z axis. The term "substantially" includes a margin of error, namely, refers to a value approximately the same.

The solar cell module 100 includes a plurality of solar cells 10, a plurality of tab leads 12, and a plurality of connecting leads 14. Each of the solar cells 10 absorbs incident light to generate photovoltaic power. The solar cells 10 include a semiconductor material such as crystalline silicon, gallium arsenide (GaAs), or indium phosphide (InP), for example. The respective solar cells 10 are illustrated with, but not limited to, a case in which crystalline silicon and amorphous silicon are stacked. Although not shown in FIG. 1, the light receiving surface and the rear surface of the respective solar cells 10 are each provided with a plurality of finger electrodes extending parallel to each other in the x-axis direction, and a plurality of (for example, two) busbar electrodes extending in the y-axis direction perpendicular to the plural finger electrodes. The busbar electrodes connect the respective finger electrodes.

The plural solar cells 10 are arranged into a matrix form on the x-y plane. In this embodiment, four solar cells 10 are aligned in the x-axis direction, and five solar cells 10 are aligned in the y-axis direction. The number of the solar cells 10 aligned in each of the x-axis direction and the y-axis direction is not limited to the number described above. The five solar cells 10 aligned in the y-axis direction are connected in series by the tab leads 12 to form a single solar cell string 16. As described above, since the four solar cells 10 are aligned in the x-axis direction, the four solar cell strings 16 each elongated in the y-axis direction are arranged in parallel in the x-axis direction. The respective solar cell strings 16 may be illustrated with only the plural solar cells 10 or with a combination of the plural solar cells 10 and the plural tab leads 12.

The respective tab leads 12 electrically connect the busbar electrode on the light receiving surface of one of the solar cells 10 adjacent to each other and the busbar electrode on the rear surface of another solar cell 10 so as to form the solar cell string 16. The adjacent two solar cells 10 are thus electrically connected to each other with the tab leads 12. The tab leads 12 are each formed of a stripe of metal foil such that aluminum foil and copper foil are soldered or coated with silver, for example. The tab leads 12 and the busbar electrodes are connected by use of resin. The resin used may be either conductive or non-conductive. When non-conductive resin is used, the tab leads 12 and the busbar electrodes are directly connected to each other so as to ensure electrical connection. The connection between the tab leads 12 and the busbar electrodes may be made by soldering instead of resin.

The plural connecting leads 14 extend in the x-axis direction and electrically connect the adjacent two solar cell strings 16 in the positive direction and the negative direction of the y axis. In the configuration described above, each of the solar cells 10 and the solar cell strings 16 may serve as a "photoelectric converter", or a combination of the solar cell strings 16 and connecting leads 14 may serve as a "photoelectric converter". The solar cell module 100 may be provided with a frame (not shown) along the peripheral edge. The frame protects the peripheral edge of the solar cell module 100, and is used when the solar cell module 100 is installed on a roof and the like.

The photoelectric converters (the solar cells 10) adjacent to each other are electrically connected by the tab leads 12 which preferably include aluminum. A catalytic reaction by the metal which is aluminum included in the tab leads 12 avoids decomposition of a first resin layer 22, a second resin layer 24 and a third resin layer 26, and suppresses a change in color of the resin included in these resin layers. The tab leads 12 including non-plated aluminum can suppress a change in color of the resin more reliably than the tab leads 12 in which copper foil is plated with silver.

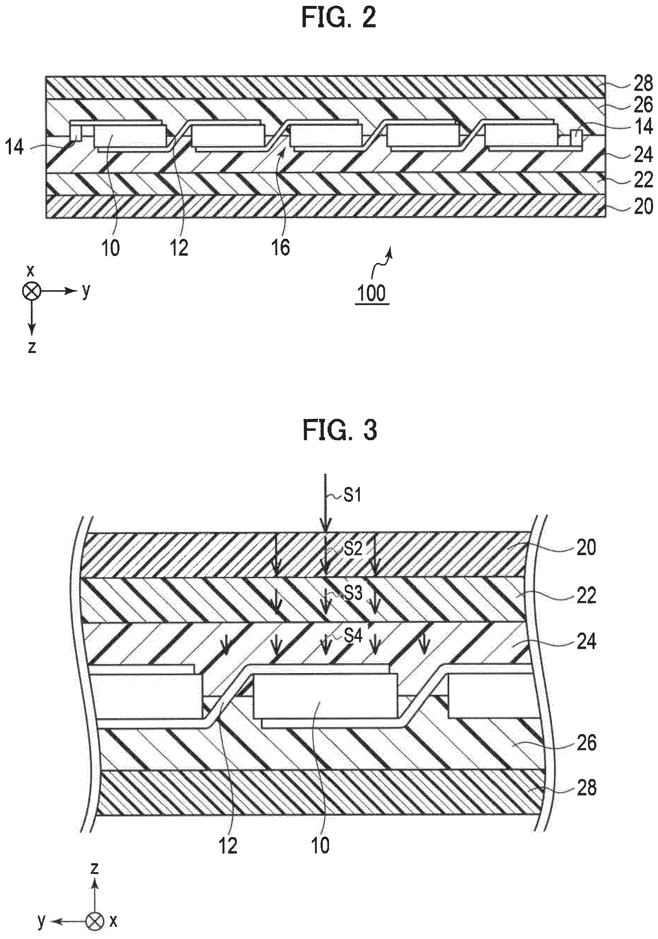

FIG. 2 is a cross-sectional view of the solar cell module 100 taken along line A-A' in FIG. 1. The solar cell module 100 includes the solar cells 10, the tab leads 12, the connecting leads 14, the solar cell strings 16, a first resin substrate 20, the first resin layer 22, the second resin layer 24, the third resin layer 26, and a second resin substrate 28. The upper side of FIG. 2 corresponds to the rear surface side, and the lower side corresponds to the light receiving surface side.

The first resin substrate 20 is provided over the light receiving surface side of the solar cell module 100 so as to protect the surface of the solar cell module 100. The first resin substrate 20 includes light-transmitting polycarbonate resin, for example. The first resin substrate 20 is formed into, but not limited to, a rectangular plate shape having a thickness of 1 mm. The polycarbonate resin is a kind of thermoplastics, and has a tensile modulus of elasticity in a range of 2.3 to 2.5 GPa and water vapor transmission rate in a range of 40 to 50 $g/m^2/day$. The tensile modulus of elasticity E is a proportionality constant defined by strain $\sigma$ and stress $\varepsilon$ in the same axial direction and expressed by the following formula:

$$E = \sigma / \varepsilon$$

The tensile modulus of elasticity is also referred to as a Young's modulus.

The first resin layer 22 is provided over one side of the first resin substrate 20 in the negative direction of the z axis. The first rein layer 22 includes gel having a tensile modulus of elasticity in a range of 0.000001 to 0.001 GPa and a loss tangent in a range of 0.1 to 0.52. Examples of such gel include silicone gel, acrylic gel, and urethane gel. The silicone gel has a tensile modulus of elasticity of 0.000005 GPa and water vapor transmission rate in a range of 300 to 2500 $g/m^2/day$. The loss tangent is a ratio G"/G' of a loss shear modulus (G") to a storage shear modulus (G') and is represented by tan $\delta$. The loss tangent refers to the amount of energy absorbed by the material upon deformation. The material absorbs the greater amount of energy as the value of tan $\delta$ is larger. The loss tangent is measured with a dynamic mechanical analyzer. The first resin layer 22 transmits light and is formed of a rectangular sheet-like material having substantially the same dimensions as the x-y plane of the first resin substrate 20. The first resin layer 22 may be in a liquid state.

The second resin layer 24 is provided over one side of the first resin layer 22 in the negative direction of the z axis. The second resin layer 24 includes thermoplastic resin such as a resin film of an EVA, polyvinyl butyral (PVB), or polyimide. Alternatively, thermosetting resin may be used. In the present embodiment, the second resin layer 24 particularly includes the EVA. The EVA has a tensile modulus of elasticity in a range of 0.01 to 0.25 GPa, water vapor transmission rate in a range of 30 to 50 $g/m^2/day$, and a loss tangent 0.05. The second resin layer 24 transmits light and is formed of a rectangular sheet-like material having substantially the same dimensions as the x-y plane of the first resin substrate 20.

As described above, the respective solar cell strings 16 are obtained such that the plural solar cells 10 aligned in the y-axis direction are connected by the tab leads 12. The plural connecting leads 14 are connected to the end of the respective solar cell strings 16 on both sides in the positive and negative directions of the y axis. The connecting leads 14 and the solar cell strings 16 are provided over one side of the second resin layer 24 in the negative direction of the z axis. The plural solar cells 10 are each formed into a plate-like shape having a light receiving surface and a rear surface.

The third resin layer 26 is provided over one side of the connecting leads 14, the solar cell strings 16, and the second resin layer 24 in the negative direction of the z axis. The connecting leads 14 and the solar cell strings 16 are thus sealed between the second resin layer 24 and the third resin layer 26. In particular, the light receiving surfaces of the solar cells 10 are arranged in contact with the second resin layer 24, and the rear surfaces of the solar cells 10 are arranged in contact with the third resin layer 26. The third resin layer 26 includes a material which may be either the same as or different from that included in the second resin layer 24. In the latter case, the third resin layer 26 includes a material having a smaller tensile modulus of elasticity than that in the second resin layer 24. For example, the second resin layer 24 includes an EVA having a tensile modulus of elasticity of greater than 0.2 GPa, and the third resin layer 26 includes sealant having a tensile modulus of elasticity of smaller than 0.2 GPa. Alternatively, the second resin layer 24 may include sealant having a tensile modulus of elasticity of greater than 0.2 GPa, and the third resin layer 26 may include an EVA having a tensile modulus of elasticity of smaller than 0.2 GPa.

The following is a case in which a load is applied to the solar cell module 100 having the configuration described above. FIG. 3 illustrates a load applied to the solar cell module 100. FIG. 3 is a partial cross-sectional view of FIG. 2, in which the z-axis direction is indicated reversely such that the upper side in FIG. 3 corresponds to the light receiving surface side. A load S1 is applied to the first resin substrate 20 from the light receiving surface side. In the present embodiment, the load S1 is presumed to be a local load caused by impact of hail. Since the tensile modulus of elasticity of the first resin substrate 20 described above is smaller than that of a glass substrate which is 70 GPa, the first resin substrate 20 causes flexure in the negative direction of the z axis due to the applied load S1 to further cause a load S2. The load S2 is a local load on the x-y plane corresponding to the amount of the flexure.

The first resin layer 22 has a smaller tensile modulus of elasticity and a larger loss tangent than each of the first resin substrate 20, the second resin layer 24, and the third resin layer 26, so as to absorb the flexure of the first resin substrate 20 to some extent. This means that a load S3 in the first resin layer 22 is smaller than the load S2 in the first resin substrate 20. The load S3 is still a local load applied to the x-y plane in the negative direction of the z axis, as in the case of the load S2.

The second resin layer 24 has a greater tensile modulus of elasticity and a smaller loss tangent than the first resin layer 22. Namely, the second resin layer 24 is harder than the first resin layer 22. The second resin layer 24 thus receives surface pressure by the load S3 on the x-y plane so as to apply a load S4 wider than the load S3 in the negative direction of the z axis. In other words, the load S4 is smaller and is dispersed on the x-y plane more widely than the load S1.

Since the load S4 applied to the solar cells 10, the tab leads 12, and the connecting leads 14 is small and dispersed on the x-y plane, the risk of causing damage to the solar cells 10, the tab leads 12, and the connecting leads 14 is reduced. When the third resin layer 26 includes the same material as the second resin layer 24, the tensile modulus of elasticity and the loss tangent are the same between the second resin layer 24 and the third resin layer 26 sealing the solar cells 10, the tab leads 12, and the connecting leads 14. The same tensile modulus of elasticity and loss tangent between the second resin layer 24 and the third resin layer 26 lead the load to be continuous at the interface between the second resin layer 24 and the third resin layer 26, so as to prevent the load applied to the solar cells 10, the tab leads 12, and the connecting leads 14 from being scattered in many directions. When the third resin layer 26 includes a material having a smaller tensile modulus of elasticity than the material in the second resin layer 24, the load is further absorbed to the third resin layer 26. Reference is made again to FIG. 2.

The second resin substrate 28 is provided over one side of the third resin layer 26 in the negative direction of the z axis. The second resin substrate 28 serves as a back sheet to protect the rear surface of the solar cell module 100. When the first resin substrate 20 is referred to as a resin substrate, the second resin substrate 28 corresponds to another resin substrate. The second resin substrate 28 includes glass epoxy resin, for example. Since glass epoxy resin has a tensile modulus of elasticity in a range of 20 to 25 GPa, the second resin substrate 28 has a greater tensile modulus of elasticity than the first resin substrate 20.

The second resin substrate 28 may include polycarbonate resin as in the case of the first resin substrate 20. In order to have the tensile modulus of elasticity of the second resin substrate 28 greater than that of the first resin substrate 20, the second resin substrate 28 has a greater thickness in the z-axis direction than the first resin substrate 20. The second resin substrate 28 may include fiber reinforced plastic (FRP). More particularly, the second resin substrate 28 may include glass fiber reinforced plastic (GFRP) or carbon fiber reinforce plastic (CFRP). The tensile modulus of elasticity of GFRP is in a range of 5 to 30 GPa, and the tensile modulus of elasticity of CFRP is in a range of 10 to 150 GPa.

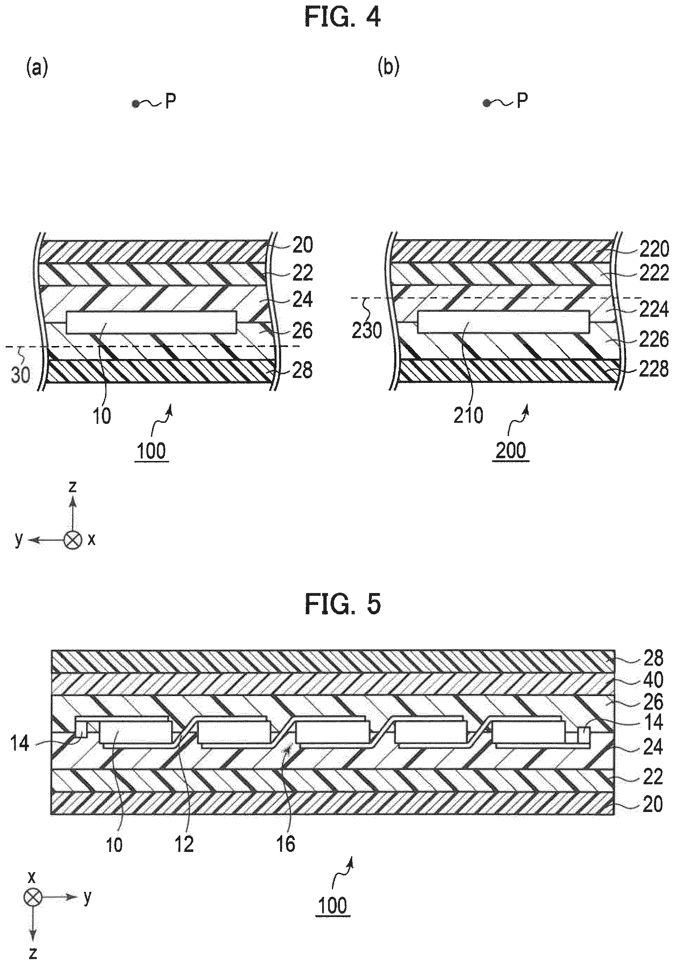

The reason that the tensile modulus of elasticity of the second resin substrate 28 is set to be greater than that of the first resin substrate 20 is described below with reference to FIG. 4(a) to (b). FIG. 4(a) to (b) illustrate a neutral axis 30 in the solar cell module 100. FIG. 4(a) is a partial cross-sectional view of FIG. 2, in which the z-axis direction is indicated reversely such that the upper side in FIG. 4(a) corresponds to the light receiving surface side. FIG. 4(a) illustrates a case in which a point P is separated from the solar cell module 100 in the positive direction of the z axis, and a bending moment is applied to the solar cell module 100 about the point P such that the solar cell module 100 protrudes on the rear surface side.

When the second resin substrate 28 has a greater tensile modulus of elasticity than the first resin substrate 20, the neutral axis 30 is present in the third resin layer 26. The neutral axis 30 refers to a part at which the material does not receive a load when the bending moment is applied to the material. While compressive stress is applied from the neutral axis 30 in the direction toward the point P, tensile stress is applied from the neutral axis 30 in the direction opposite to the direction toward the point P. Therefore, the compressive stress is applied to the solar cells 10 when the second resin substrate 28 has the same thickness as the first resin substrate 20 and has a greater tensile modulus of elasticity than the first resin substrate 20. The solar cells 10 typically have low resistance to the tensile stress and high resistance to the compressive stress. The second resin substrate 28 having a greater tensile modulus of elasticity than the first resin substrate 20 suppresses damage to the solar cells 10 accordingly.

FIG. 4(b) illustrates a solar cell module 200 as a comparative example of the solar cell module 100. Solar cells 210, a first resin substrate 220, a first resin layer 222, a second resin layer 224, and a third resin layer 226 in the solar cell module 200 correspond to the solar cells 10, the first resin substrate 20, the first resin layer 22, the second resin layer 24, and the third resin layer 26, respectively. A second resin substrate 228 includes a material having a smaller tensile modulus of elasticity than the first resin substrate 220. Such a difference causes a neutral axis 230 to be provided in the second resin layer 240 closer to the point P than the neutral axis 30. As a result, tensile stress is applied to the solar cells 210 to increase the risk of causing damage to the solar cells 210, as compared with the case shown in FIG. 4(a). Reference is made again to FIG. 2.

The descriptions have been made above mainly with regard to the tensile modulus of elasticity of the first resin substrate 20 and the like in view of the improvement of the resistance to impact in the solar cell module 100. The following descriptions focus on the improvement in resistance to water of the solar cell module 100. As described above, the first resin substrate 20 is a substrate of polycarbonate resin, instead of a glass substrate, so as to achieve a reduction in weight of the solar cell module 100. While the glass substrate has water vapor transmission rate of approximately zero, the polycarbonate resin has water vapor transmission rate of 40 to 50 $g/m^2/day$ and tends to allow water to permeate thereinto. In view of such circumstances, the second resin layer 24 is used that has smaller water vapor transmission rate than the first resin layer 22 in order to improve the resistance to water. The second resin layer 24 thus decreases the probability that water reaches the solar cells 10.

The effects of the solar cell module 100 are described below with reference to results of an impact and drop test performed on the solar cell module 100. Table 1 indicates the results of the impact and drop test performed on the solar cell module 100. In this embodiment, the impact and drop test was performed in accordance with JIS C8917:2005, "Environmental and endurance test method for crystalline solar PV modules; Annex 7 Hail Impact Testing A-8". In Example 1, polycarbonate resin, silicone gel, sealant, sealant, and glass epoxy resin were used to correspond to the first resin substrate 20, the first resin layer 22, the second resin layer 24, the third resin layer 26, and the second resin substrate 28, respectively. Example 1 was not damaged when a steel ball or ice ball was dropped from a height of 100 cm.

[Table 1]

| Element | Example 1 | Comparative Example 1 | Comparative Example 2 |
|---|---|---|---|
| First Resin Substrate | Polycarbonate Resin (1 mm) | Polycarbonate Resin (1 mm) | Glass (3.2 mm) |
| First Resin Layer | Silicone Gel (1 mm) | Olefin-based Resin (0.6 mm) | - |
| Second Resin Layer | Olefin-based Resin (0.6 mm) | Olefin-based Resin (0.6 mm) | Olefin-based Resin (0.6 mm) |
| Third Resin Layer | Olefin-based Resin (0.6 mm) | Olefin-based Resin (0.6 mm) | Olefin-based Resin (0.6 mm) |
| Second Resin Substrate | Glass Epoxy Resin (1 mm) | Glass Epoxy Resin (1 mm) | PET (0.1 mm) |
| 100 cm | Good (Not Damaged) | Failed (Damaged) | Good (Not Damaged) |
| 80cm | Good (Not Damaged) | Failed (Damaged) | Good (Not Damaged) |
| 50 cm | Good (Not Damaged) | Good (Not Damaged) | Good (Not Damaged) |
| 40 cm | Good (Not Damaged) | Good (Not Damaged) | Good (Not Damaged) |
| 30 cm | Good (Not Damaged) | Good (Not Damaged) | Good (Not Damaged) |

In Comparative Example 1, polycarbonate resin, sealant, sealant, sealant, and glass epoxy resin were used to correspond to the first resin substrate 20, the first reis layer 22, the second resin layer 24, the third resin layer26, and the second resin substrate 28, respectively. Comparative Example 1 was not damaged when the steel ball or ice ball was dropped from a height of 50 cm, but was damaged when the ball was dropped from the height of each of 100 cm and 80 cm. In Comparative Example 2, glass, sealant, sealant, and polyethylene terephthalate (PET) resin were used to correspond to the first resin substrate 20, the second resin layer 24, the third resin layer 26, and the second resin substrate 28, respectively. Comparative Example 2 was not damaged when the steel ball or ice ball was dropped from the height of 100 cm. The resistance to impact in Example 1 is improved as compared with the Comparative Example 1. The resistance to impact in Example 1 is substantially the same as that in the Comparative Example 2 within this test.

Next, the resin substrate and the other resin substrate are illustrated with a case in which the other resin substrate has greater flexural rigidity than the resin substrate. In the solar cell module 100 according to the present embodiment, the other resin substrate (the second resin substrate 28) preferably has greater flexural rigidity than the resin substrate (the first resin substrate 20). More particularly, the flexural rigidity of the second resin substrate 28 per meter width is preferably greater than the flexural rigidity of the first resin substrate 20 per meter width. The resistance to impact such as hail in the solar cell module 100 can be improved accordingly.

The flexural rigidity is expressed by the following mathematical formula (1):
[Math 1]

$$\text{Flexural rigidity } (\text{N·m}^2) = \text{flexural modulus of elasticity (Pa)} \times \text{second moment of area } (\text{m}^4) \qquad (1)$$

The flexural modulus of elasticity may be measured as follows in accordance with JIS K7171:2016 (Plastics-Determination of flexural properties). In particular, the flexural modulus of elasticity may be measured such that a specimen is compressed at a test temperature of 25 °C and a test speed of 5 mm/min, for example.
[Math 2]

$$E_f = (\sigma_{f2} - \sigma_{f1}) / (\varepsilon_{f2} - \varepsilon_{f1}) \qquad (2)$$

where, $E_f$ is the flexural modulus of elasticity (Pa), $\sigma_{f1}$ is flexural stress (Pa) measured with deflection $S_1$, $\sigma_{f2}$ is flexural stress (Pa) measured with deflection $S_2$, and $\varepsilon_{fi}$ is flexural strain ($\varepsilon_1$ = 0.0005 and $\varepsilon_2$ = 0.0025).

The deflection is calculated according to the following mathematical formula (3):
[Math 3]

$$S_i = \varepsilon_{fi} L^2 / 6h \qquad (3)$$

where, $S_i$ is the deflection (mm), $\varepsilon_{fi}$ is flexural strain ($\varepsilon_1$ = 0.0005 and $\varepsilon_2$ = 0.0025), L is a span between the supports (mm), and h is an average thickness of the specimen (mm).

When the specimen has a rectangular cross section, the second moment of area is expressed by the following mathematical formula (4):
[Math 4]

$$I = bh^3 / 12 \qquad (4)$$

where, I is the second moment of area ($\text{m}^4$), b is a width of the cross section (m), and h is a height of the cross section (m).

The resistance to impact when the second resin substrate 28 has a smaller flexural rigidity than the first resin substrate 20 was evaluated in the following examples. It should be understood that the present embodiment is not intended to be limited to the following examples.

[Example 2]

A first resin substrate having a thickness of 1 mm, a first resin layer having a thickness of 1 mm, a second resin layer having a thickness of 0.6 mm, photoelectric converters, a third resin layer having a thickness of 0.6 mm, and a second resin substrate having a thickness of 1 mm were sequentially stacked from above, and compressed and heated at 145 °C under reduced pressure, so as to prepare a solar cell module. The material used for the first resin substrate was polycarbonate (PC). The material used for the first resin layer was gel. The material used for the second resin layer was polyolefin (PO). The photoelectric converters used were solar cells. The material used for the third resin layer was polyolefin (PO). The material used for the second resin substrate was polycarbonate (PC) (with a flexural modulus of elasticity of 2.3 GPa).

[Example 3]

A solar cell module was prepared in the same manner as in Example 2 except that glass epoxy (with a flexural modulus of elasticity of 20 GPa) was used for the second resin substrate.

[Example 4]

A solar cell module was prepared in the same manner as in Example 2 except that glass epoxy (with a flexural modulus of elasticity of 20 GPa) was used for the second resin substrate and the thickness of the second resin substrate was set to 2 mm.

(Resistance to impact)

The test for the resistance to impact was performed under the following test conditions in accordance with the hail impact test prescribed in Annex 7 in JIS C8917:2005 (Environmental and endurance test method for crystalline solar PV modules). In particular, a steel ball having a mass of 227 g (± 2 g) and a diameter of approximately 38 mm was dropped on the central point of the first resin substrate 20 of the solar cell module obtained in each example from a height of each of 1 m and 20 cm without force applied. The respective solar cell modules were rated "A" when the photoelectric converters were not damaged by the steel ball dropped from the height of 1 m, rated "B" when the photoelectric converters were not damaged by the steel ball dropped from the height of 20 cm but damaged by the steel ball dropped from the height of 1 m, and rated "C" when the photoelectric converters were damaged by the steel ball dropped from the height of 20 cm. The flexural rigidity in each example is indicated by the ratio with respect to Example 2 such that the flexural rigidity of Example 2 is readjusted to "1".

[Table 2]

| | First Resin Substrate | Second Resin Substrate | | | Evaluation Results (Height When Damaged) |
|---|---|---|---|---|---|
| | Material | Material | Thickness | Flexural Rigidity (Ratio) | |
| Example 2 | Polycarbonate | Polycarbonate | 1 mm | 1 | B (1 m) |
| Example 3 | Polycarbonate | Glass Epoxy | 1 mm | 8.7 | B (1 m) |
| Example 4 | Polycarbonate | Glass Epoxy | 2 mm | 70 | A (above 1 m) |

According to the evaluation of the resistance to impact in each example by the hail impact test, the photoelectric converters in the solar cell modules in Examples 2 and 3 were not damaged by the steel ball dropped from the height of 20 cm but damaged by the steel ball dropped from the height of 1 m, as shown in Table 2. The photoelectric converters in the solar cell module in Example 4 were not damaged by the steel ball dropped from the height of 1 m.

The results obtained in Examples 2 to 4 revealed that the resistance to impact is improved when the flexural rigidity of the second resin substrate 28 is greater than the flexural rigidity of the first resin substrate 20. The test implies that the greater flexural rigidity of the second resin substrate 28 can suppress flexure of the entire solar cell module 100 upon the impact, so as to avoid damage to the solar cell module 100. In view of this, in the present embodiment, the flexural rigidity of the second resin substrate 28 is preferably greater than the flexural rigidity of the first resin substrate 20. Namely, the solar cell module 100 preferably further includes the second resin substrate 28 provided over the third resin layer 26 and having greater flexural rigidity than the first resin substrate 20.

The second resin substrate 28 also preferably, but not necessarily, has a smaller coefficient of thermal expansion than the first resin substrate 20. The resistance to thermal shock thus can be improved in the solar cell module 100, and breakage of the tab leads 12 caused by a change in temperature can be prevented.

The resistance to thermal shock when the second resin substrate 28 has a smaller coefficient of linear thermal expansion than the first resin substrate 20 was evaluated in the following examples. It should be understood that the present embodiment is not intended to be limited to the following examples.

[Example 5]

A first resin substrate having a thickness of 1 mm, a first resin layer having a thickness of 1 mm, a second resin layer having a thickness of 0.6 mm, photoelectric converters, a third resin layer having a thickness of 0.6 mm, and a second resin substrate having a thickness of 2 mm were sequentially stacked from above, and compressed and heated at 145 °C under reduced pressure, so as to prepare a solar cell module. The material used for the first resin substrate 20 was polycarbonate (PC) (with a coefficient of linear thermal expansion of $70 \times 10^{-6}K^{-1}$). The material used for the first resin layer was gel. The material used for the second resin layer was an ethylene-vinyl acetate copolymer (EVA). The photoelectric converters used were solar cells. The material used for the third resin layer was an ethylene-vinyl acetate copolymer (EVA). The material used for the second resin substrate was carbon-fiber reinforced plastic (CFRP) (with a coefficient of linear thermal expansion of $2.5 \times 10^{-6}K^{-1}$).

[Example 6]

A solar cell module was prepared in the same manner as in Example 5 except that glass epoxy (with a coefficient of linear thermal expansion of $20 \times 10^{-6}K^{-1}$) was used for the second resin substrate.

[Comparative Example 3]

A solar cell module was prepared in the same manner as in Example 5 except that glass (with a coefficient of linear thermal expansion of $9\times 10^{-6}K^{-1}$) was used for the second resin substrate.

[Comparative Example 4]

A solar cell module was prepared in the same manner as in Example 5 except that the first resin layer was not provided.

[Comparative Example 5]

A solar cell module was prepared in the same manner as in Example 5 except that the first resin layer was not provided and that glass (with a coefficient of linear thermal expansion of $9\times 10^{-6}K^{-1}$) was used for the second resin substrate.

[Comparative Example 6]

A solar cell module was prepared in the same manner as in Example 5 except that the first resin layer was not provided and that glass epoxy (with a coefficient of linear thermal expansion of $20 \times 10^{-6}K^{-1}$) was used for the second resin substrate.

[Comparative Example 7]

A solar cell module was prepared in the same manner as in Example 5 except that the first resin layer was not provided and that polycarbonate (PC) (with a coefficient of linear thermal expansion of $70 \times 10^{-6}1K^{-1}$) was used for the second resin substrate.

(Resistance to thermal shock)

The test for the resistance to thermal shock was performed under the following test conditions in accordance with the temperature cycle test prescribed in JIS C8990:2009 (IEC 61215:2005) (Crystalline silicon terrestrial photovoltaic (PV) modules-Design qualification and type approval). In particular, the solar cell module obtained in each example was placed in a test chamber, and the temperature of the solar cell module was periodically varied between -40 °C ($\pm$ 2 °C) and 85 °C ($\pm$ 2 °C). The tab leads connecting the solar cells were visually checked after the temperature cycling under such conditions was repeated 25 cycles, 50 cycles, and 200 cycles in the temperature cycle test. The respective solar cell modules were rated "AA" when the tab leads were not cut off after 200 cycles, and rated "A" when the tab leads were not cut off after 50 cycles but cut off after 200 cycles. The respective solar cell modules were rated "B" when the tab leads were not cut off after 25 cycles but cut off after 50 cycles, and rated "C" when the tab leads were cut off after 25 cycles. A temperature variation speed between the lower limit and the upper limit was set to 1.4 °C per hour, the time for keeping the lowest temperature was set to 60 minutes, the time for keeping the highest temperature was set to one hour and 20 minutes, and the period of one cycle was set to five hours and 20 minutes. The temperature cycle test was performed at least three times.

[Table 3]

| | First Resin Substrate | | First Resin Layer | Second Resin Substrate | | Evaluation Results (cycles when cut off) |
|---|---|---|---|---|---|---|
| | Material | Coefficient of Linear Thermal Expansion ($\times 10^{-6}K^{-1}$) | Material | Material | Coefficient of Linear Thermal Expansion ($\times 10^{-6}K^{-1}$) | |
| Example 5 | PC | 70 | Gel | CFRP | 2.5 | AA (over 200) |
| Example 6 | PC | 70 | Gel | Glass Epoxy | 20 | B (50) |
| Comparative Example 3 | PC | 70 | Gel | Glass | 9 | A (200) |
| Comparative Example 4 | PC | 70 | - | CFRP | 2.5 | A (200) |
| Comparative Example 5 | PC | 70 | - | Glass | 9 | B (50) |
| Comparative Example 6 | PC | 70 | - | Glass Epoxy | 20 | C (25) |
| Comparative Example 7 | PC | 70 | - | PC | 70 | C(25) |

According to the evaluation of the resistance to thermal shock in each example by the temperature cycle test, the tab leads in the solar cell module in Example 5 were not cut off after 200 cycles, as shown in Table 3. The tab leads in the solar cell modules in Comparative Examples 3 and 4 were not cut off after 50 cycles but cut off after 200 cycles. The tab leads in the solar cell modules in Example 6 and Comparative Example 5 were not cut off after 25 cycles but cut off after 50 cycles. The tab leads in the solar cell modules in Comparative Examples 6 and 7 were cut off after 25 cycles. The results revealed that the resistance to thermal shock in the solar cell module 100 is improved when the coefficient of linear thermal expansion of the second resin substrate 28 is smaller than the coefficient of linear thermal expansion of the first resin substrate 20. The comparison between the group of Examples 5 and 6 and Comparative Example 3 and the group of Comparative Examples 4 to 6 also revealed that the use of the gel having a relatively small tensile modulus of elasticity in the first resin layer improves the resistance to thermal shock.

The results obtained in Examples 5 and 6 and Comparative Examples 3 to 7 revealed that the resistance to thermal shock is improved when the coefficient of linear thermal expansion of the second resin substrate 28 is smaller than the coefficient of linear thermal expansion of the first resin substrate 20. The test implies that the smaller coefficient of thermal expansion of the second resin substrate 28 can suppress thermal expansion or contraction of the resin layer located adjacent to the photoelectric converters, so as to prevent breakage of the tab leads caused. In view of this, in the present embodiment, the coefficient of thermal expansion of the second resin substrate 28 is preferably smaller than the coefficient of thermal expansion of the first resin substrate 20. Namely, the solar cell module 100 preferably further includes the second resin substrate 28 provided over the third resin layer 26 and having a smaller coefficient of thermal expansion than the first resin substrate 20.

The thickness of the second resin substrate 28 is preferably set to, but not limited to, 0.1 mm or greater and 10 mm or less, more preferably 0.2 mm or greater and 5.0 mm or less. The thickness set as described above can suppress flexure of the second resin substrate 28 and achieve a further reduction in weight of the solar cell module 100.

The tensile modulus of elasticity of the second resin substrate 28 is preferably set to, but not limited to, 1.0 GPa or greater and 200 GPa or less, more preferably 10 GPa or greater and 100 GPa or less. The tensile modulus of elasticity of the second resin substrate 28 is preferably greater than the tensile modulus of elasticity of the first resin layer 22. Namely, the tensile modulus of elasticity of the first resin layer 22 is preferably smaller than the tensile modulus of elasticity of each of the first resin substrate 20, the third resin layer 26, and the second resin substrate 28.

A method of manufacturing the solar cell module 100 according to the above embodiment is described below. The solar cell module 100 is manufactured such that the solar cell strings 16 are laminated with the first resin substrate 20, the first resin layer 22, the second resin layer 24, the third resin layer 26, and the second resin substrate 28. In a laminating apparatus, the first resin substrate 20, a resin sheet composing the first resin layer 22, a resin sheet composing the second resin layer 24, the strings of the solar cells 10, a resin sheet composing the third resin layer 26, and the second resin substrate 28 are sequentially stacked on a heater or the like. The stacked body is heated to approximately 150 °C in a vacuum, for example. The stacked body is continuously heated while the respective members are pressed toward the heater under atmospheric pressure, so as to cross-link the resin compositions of the resin sheets. A frame is then attached to the stacked body so as to obtain the solar cell module 100.

According to the present embodiment, the tensile modulus of elasticity of the first resin layer 22 is smaller than the tensile modulus of elasticity of each of the first resin substrate 20, the second resin layer 24, and the third resin layer 26, so as to decrease an external load in the first resin layer 22. The tensile modulus of elasticity of the second resin layer 24 in contact with the solar cells 10 and the like is greater than the first resin layer 22, so as to disperse the load. Since the load applied to the solar cells 10 and the like is decreased and dispersed, damage to the solar cells 10 and the like can be suppressed. The suppression of damage to the solar cells 10 and the like leads to the improvement in the resistance to impact in the solar cell module 100 accordingly.

The solar cells 10 and the like are sandwiched between the second resin layer 24 and the third resin layer 26 so as to stably hold the solar cells 10 and the like. The solar cells 10 and the like are sealed between the second resin layer 24 and the third resin layer 26 so as to further tightly hold the solar cells 10 and the like. When the second resin layer 24 and the third resin layer 26 include the same material, the load applied to the solar cells 10 and the like is prevented from being scattered in many directions. When the second resin layer 24 and the third resin layer 26 include different materials, and the tensile modulus of elasticity of the third resin layer 26 is smaller than the tensile modulus of elasticity of the second resin layer 24, the load applied to the solar cells 10 and the like can be decreased.

Since the second resin substrate 28 is provided over the third resin layer 26, the solar cell module 100 can also be protected on the rear surface side. The tensile modulus of elasticity of the second resin substrate 28 greater than the tensile modulus of elasticity of the first resin substrate 20 can avoid causing tensile stress applied to the solar cells 10. The suppression of tensile stress applied to the solar cells 10 can suppress damage to the solar cells 10. The water vapor transmission rate of the second resin layer 24 smaller than the water vapor transmission rate of the first resin layer 22 can suppress water entrance toward the solar cells 10. Since the entrance of water to the solar cells 10 is suppressed, a fault in the solar cells 10 can be prevented.

The following is a summary of the present embodiment. The solar cell module 100 according to an aspect of the present embodiment includes the resin substrate (the first resin substrate 20), the first resin layer 22, the second resin layer 24, the photoelectric converter (the solar cell 10, the solar cell string 16) provided over the second resin layer 24, and the third resin layer 26. The first resin layer 22 is provided over the resin substrate. The second resin layer 24 is provided over the first resin layer 22. The third resin layer 26 is provided over the photoelectric converter and the second resin layer 24. The tensile modulus of elasticity of the first resin layer 22 is smaller than the tensile modulus of elasticity of each of the resin substrate, the second resin layer 24, and the third resin layer 26.

The water vapor transmission rate of the second resin layer 24 may be smaller than the water vapor transmission rate of the first resin layer 22.

The photoelectric converter may be formed into a plate-like shape having a light receiving surface and a rear surface, the light receiving surface of the photoelectric converter may be arranged in contact with the second resin layer 24, and the rear surface of the photoelectric converter may be arranged in contact with the third resin layer 26.

The photoelectric converter may be sealed between the second resin layer 24 and the third resin layer 26.

The second resin layer 24 and the third resin layer 26 may include an identical material.

The second resin layer 24 and the third resin layer 26 may include different materials, and the tensile modulus of elasticity of the third resin layer 26 may be smaller than the tensile modulus of elasticity of the second resin layer 24.

Another resin substrate (the second resin layer 28) may further be provided over the third resin layer 26.

The tensile modulus of elasticity of the other resin substrate may be greater than the tensile modulus of elasticity of the resin substrate.

The solar cell module 100 according to another aspect of the present embodiment includes the resin substrate (the first resin substrate 20), the first resin layer 22, the second resin layer 24, the photoelectric converters (the solar cells 10, the solar cell strings 16) provided over the second resin layer 24, and the third resin layer 26. The first resin layer 22 is provided over the resin substrate. The second resin layer 24 is provided over the first resin layer 22. The third resin layer 26 is provided over the photoelectric converters and the second resin layer 24. The adjacent photoelectric converters are electrically connected to each other with the tab leads 12. The tensile modulus of elasticity of the first resin layer 22 is smaller than the tensile modulus of elasticity of each of the resin substrate, the second resin layer 24, and the third resin layer 26.

(Embodiment 2)

Embodiment 2 is described below. Embodiment 2 relates to a solar cell module including a plurality of solar cells, as in the case of Embodiment 1. The solar cell module preferably ensures improved resistance to impact when a resin substrate is used. While the solar cell module according to Embodiment 2 has the configuration similar to the case described above, the solar cell module achieves improvement in symmetry of the structure in the z-axis direction so as to prevent deformation. The points different from the case described above will mainly be described below.

FIG. 5 is a cross-sectional view of the solar cell module 100 according to Embodiment 2. FIG. 5 illustrates the solar cell module 100 in the same manner as FIG. 2. The solar cell module 100 includes the solar cells 10, the tab leads 12, the connecting leads 14, the solar cell strings 16, the first resin substrate 20, the first resin layer 22, the second resin layer 24, the third resin layer 26, the second resin substrate 28, and a fourth resin layer 40. The solar cells 10, the tab leads 12, the connecting leads 14, the solar cell strings 16, the first resin substrate 20, the first resin layer 22, the second resin layer 24, the third resin layer 26, and the second resin substrate 28 are the same as those in the case described above, and the explanations thereof are not repeated below.

The fourth resin layer 40 is provided between the second resin substrate 28 and the third resin layer 26. The fourth resin layer 40 includes gel such as silicone gel, acrylic gel, or urethane gel as in the case of the first resin layer 22, and includes the same material as the first resin layer 22, for example. The tensile modulus of elasticity of the fourth resin layer 40 is thus smaller than the tensile modulus of elasticity of each of the first resin substrate 20, the second resin layer 24, the third resin layer 26, and the second resin substrate 28.

According to the present embodiment, the fourth resin layer 40 is provided between the second resin substrate 28 and the third resin layer 26. Since the tensile modulus of elasticity of the fourth resin layer 40 is smaller than the tensile modulus of elasticity of each of the first resin substrate 20, the second resin layer 24, the third resin layer 26, and the second resin substrate 28, the symmetry of the structure in the thickness direction is improved. The improvement in the symmetry of the structure in the thickness direction suppresses deformation of the solar cell module 100 so as to improve the resistance to impact in the solar cell module 100.

The following is a summary of the present embodiment. The fourth resin layer 40 may further be provided between the other resin substrate (the second resin substrate 28) and the third resin layer 26. The tensile modulus of elasticity of the fourth resin layer 40 is smaller than the tensile modulus of elasticity of each of the resin substrate (the first resin substrate 20), the second resin layer 24, the third resin layer 26, and the other resin substrate.

(Embodiment 3)

Embodiment 3 is described below. Embodiment 3 relates to a solar cell module including a plurality of solar cells, as in the case of Embodiment 1. The solar cell module preferably ensures improved resistance to thermal shock when a resin substrate is used. While the solar cell module according to Embodiment 3 has the configuration similar to the case described above, the solar cell module further includes a low thermal expansion layer so as to improve the resistance to thermal shock. The points different from the case described above will mainly be described below.

<Low thermal expansion layer 50>

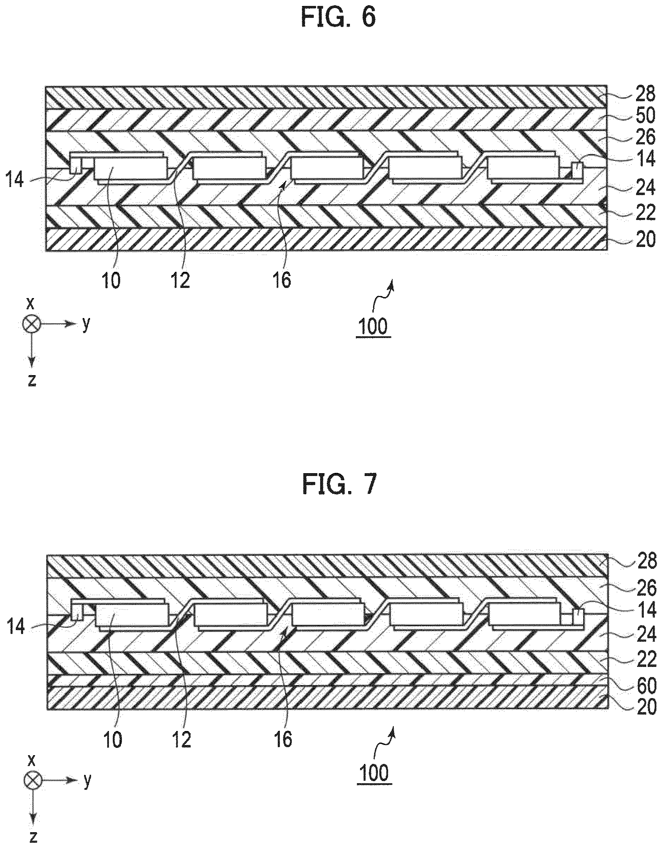

It has been confirmed according to the results obtained in Examples 5 and 6 and Comparative Examples 3 to 7 that the resistance to thermal shock is improved when the coefficient of linear thermal expansion of the second resin substrate 28 is smaller than the coefficient of linear thermal expansion of the first resin substrate 20. This effect can also be achieved when a low thermal expansion layer 50 is provided between the photoelectric converters 10 and the second resin substrate 28. The low thermal expansion layer 50 is therefore preferably provided between the photoelectric converters 10 and the second resin substrate 28. In particular, as shown in FIG. 6, the solar cell module 100 preferably includes the low thermal expansion layer 50 provided over the third resin layer 26 and having a smaller coefficient of thermal expansion than the first resin substrate 20.

The shape of the low thermal expansion layer 50 is not particularly limited, and may be selected from a circular shape, an elliptic shape, and a polygonal shape such as a rectangular shape, depending on purposes. The size of the low expansion layer 50 is not particularly limited, and may be arranged along the tab leads 12. Such an arrangement can reduce costs of the solar cell module 100 including the low thermal expansion layer 50 which is relatively expensive, and improve the resistance to thermal shock. The arrangement of the low thermal expansion layer 50 along the tab leads 12 may be made either such that the low thermal expansion layer 50 is provided in contact with the upper side of the photoelectric converters 10 in the vertical direction or such that the low thermal expansion layer 50 is provided above the photoelectric converters 10 in the vertical direction with another layer interposed therebetween. As used herein, the upper side in the vertical direction is the upper side of the solar cell module 100 in the stacking direction (the z-axis direction). The low thermal expansion layer 50 is preferably arranged to cover the entire upper surface of the resin layer provided between the photoelectric converters 10 and the second resin substrate 28 in order to further improve the resistance to thermal shock. More particularly, the low thermal expansion layer 50 is preferably provided in contact with the third resin layer 26 to cover the entire upper surface of the third resin layer 26.

The material used for the low thermal expansion layer 50 is not particularly limited, and examples thereof include glass, paper, glass fiber, a ceramic sheet, and a CFRP sheet. The material used for the low thermal expansion layer 50 preferably has a coefficient of thermal expansion which is smaller than or equal to a coefficient of thermal expansion of glass. In particular, the coefficient of linear thermal expansion of the low thermal expansion layer 50 is preferably greater than zero and smaller than or equal to $10 \times 10^{-6} K^{-1}$.

As described above, the solar cell module 100 according to the present embodiment may further include the low thermal expansion layer 50 provided over the third resin layer 26 and having a smaller coefficient of thermal expansion than the resin substrate (the first resin substrate 20). Accordingly, the resistance to thermal shock in the solar cell module 100 can be improved.

[Embodiment 4]

Embodiment 4 is described below. Embodiment 4 relates to a solar cell module including a plurality of solar cells, as in the case of Embodiment 1. The solar cell module preferably ensures improved resistance to thermal shock. While the solar cell module according to Embodiment 4 has the configuration similar to the case described above, the solar cell module further includes a lubricant layer. The points different from the case described above will mainly be described below.

<Lubricant layer 60>

As shown in FIG. 7, the solar cell module 100 preferably further includes a lubricant layer 60 provided between the first resin substrate 20 and the first resin layer 22 to have a coefficient of static friction between the first resin substrate 20 and the first resin layer 22 in a range of 0.0001 to 0.1. The lubricant layer 60 further included in the solar cell module 100 can suppress direct transmission of thermal expansion or contraction caused in the first resin substrate 20 to the first resin layer 22 owing to the lubricant effect of the lubricant layer 60. The suppression of transmission of the thermal expansion or contraction caused in the first resin substrate 20 prevents breakage of the tab leads 12 more reliably, so as to improve the resistance to thermal shock in the solar cell module 100. The coefficient of static friction between the first resin substrate 20 and the first resin layer 22 is preferably set to 0.0001 or greater so as to improve the resistance to thermal shock in the solar cell module 100. The coefficient of static friction between the first resin substrate 20 and the first resin layer 22 is preferably set to 0.1 or smaller so as to improve adhesion between the first resin substrate 20 and the first resin layer 22.

The coefficient of static friction between the first resin substrate 20 and the first resin layer 22 may be measured in accordance with the method prescribed in JIS K7125:1999 (Plastics-Film and sheeting-Determination of the coefficients of friction).

The material used for the lubricant layer 60 preferably includes grease. The grease starts flowing when external force is applied and the external force is greater than or equal to a yield value, while the grease has large fluid resistance when the external force is smaller than the yield value. Accordingly, the grease can improve the resistance to thermal shock in the solar cell module 100 and facilitate the handling of the solar cell module 100.

The grease is a lubricant in a semi-solid state or a solid state obtained such that base oil is mixed with a thickener. The grease may further include a dispersant and an antioxidant as appropriate in addition to the base oil and the thickener.

Examples of base oil include refined mineral oil, a synthetic lubricant, and mixed oil thereof. The refined mineral oil may be obtained such that crude oil is distilled. Examples of synthetic lubricants include polyolefin, polyester, polyalkylene glycol, alkylbenzene, and alkylnaphthalene.

The thickener may be a soap thickener or a non-soap thickener. Examples of soap thickeners include a metal soap thickener such as a calcium soap thickener, an aluminum soap thickener, and a lithium soap thickener, and a complex soap thickener such as a calcium complex thickener, an aluminum complex thickener, and a lithium complex thickener. Examples of non-soap thickeners include a urea thickener such as a diurea thickener, a triurea thickener, and a polyurea thickener, an organic thickener such as a polytetrafluoroethylene (PTFE) thickener and a sodium terephlate thickener, and an inorganic thickener such as a bentonite thickener and a silica gel thickener.

Examples of the grease include silicon grease, silicone grease, fluoroether grease, and fluoroalkyl grease. Particularly, the grease preferably includes at least one of the silicone grease and the fluoroalkyl grease (Teflon (registered trademark) grease).

The grease is preferably in a semi-solid state at a temperature in a range of -40 to 150 °C. The semi-solid state at the temperature in the range of -40 to 150 °C can reduce leakage of the grease to facilitate the handling of the solar cell module 100.

The dropping point of the grease is preferably 150 °C or lower. The grease having such a dropping point can keep the lubrication between the first resin substrate 20 and the first resin layer 22 when the temperature of the solar cell module 100 is increased. The dropping point may be measured in accordance with the dropping point test method prescribed in JIS K2200:2013 (Lubricating grease).

The melting point of the grease is preferably -40 °C or higher. The grease having such a melting point can keep the lubrication between the first resin substrate 20 and the first resin layer 22 and improve the resistance to thermal shock in the solar cell module 100 in a cold district.

The coefficient of static friction between the first resin substrate 20 and the first resin layer 22 at -40 °C is preferably in the range of 0.0001 to 0.1. The coefficient of static friction between the first resin substrate 20 and the first resin layer 22 at -40 °C in such a range can improve the resistance to thermal shock in the solar cell module 100 in a cold district.

The thickness of the lubricant layer 60 is preferably in a range of 0.01 $\mu$m to 100 $\mu$m. The thickness of the lubricant layer 60 is more preferably in a range of 0.01 $\mu$m to 75 $\mu$m, particularly preferably in a range of 0.01 $\mu$m to 50 $\mu$m, in view of the adhesive properties.

As described above, the solar cell module 100 according to the present embodiment may further include the lubricant layer 60 provided between the resin substrate (the first resin substrate 20) and the first resin layer 22. The coefficient of static friction between the resin substrate and the first resin layer 22 is in the range of 0.0001 to 0.1. Accordingly, the resistance to thermal shock in the solar cell module 100 can be improved.

(Embodiment 5)

Embodiment 5 is described below. Embodiment 5 relates to a solar cell module including a plurality of solar cells, as in the case of Embodiment 1. The solar cell module preferably can reduce the size of bubbles generated in the solar cell module. While the solar cell module according to Embodiment 5 has the configuration similar to the case described above, the solar cell module is provided with slits in the first resin layer 22 so as to reduce the size of bubbles. The points different from the case described above will mainly be described below.

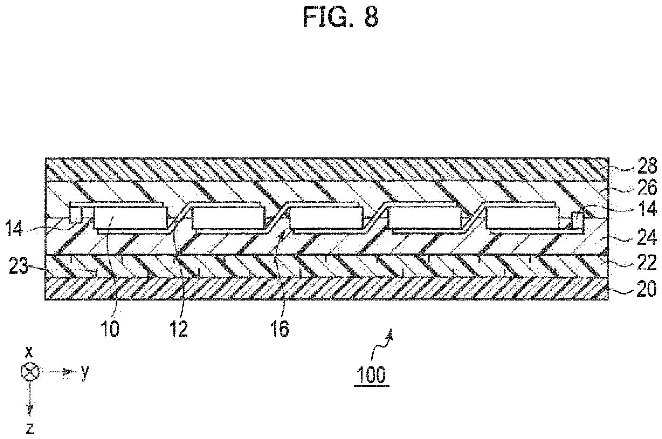

As shown in FIG. 8, the first resin layer 22 is preferably provided with slits 23 when the material used for the first resin layer 22 is gel. The first resin layer 22 therefore preferably includes gel and the first resin layer 22 is provided with the slits 23. The slits 23 allow bubbles derived from the use of the solar cell module 100 for a long period of time or bubbles entering during the manufacture of the solar cell module 100 to move therethrough in the first resin layer 22. The bubbles thus can easily come out of the solar cell module 100. Even if the bubbles cannot completely come out of the solar cell module 100, the bubbles move through the slits 23 to be dispersed, so as to reduce the size of the bubbles. The bubbles in the solar cell module 100 are thus hardly recognized visually. Accordingly, the slits 23 prevent the bubbles in the solar cell module 100 from blocking sunlight and minimize a defect in external appearance of the solar cell module 100.

The position of the slits 23 provided is not particularly limited, and the slits 23 may be provided on the surface of the first resin layer 22. In particular, the slits 23 may be provided at least either on the surface of the first resin layer 22 toward the first resin substrate 20 or on the surface of the first resin layer 22 toward the third resin layer 26. In order to easily get rid of bubbles, the slits 23 are preferably provided on the surface of the first resin layer 22 toward the first resin substrate 20 and on the surface of the first resin layer 22 toward the third resin layer 26, as shown in FIG. 8.

The size of the slits 23 in the stacking direction of the solar cell module 100 is preferably in a range of 5 to 99% of the thickness of the first resin layer 22. The slits 23 having such a size can easily get rid of bubbles and keep the strength of the first resin layer 22. The slits 23 having such a size can further reduce a local load in the first resin layer 22. The size of the slits 23 in the stacking direction of the solar cell module 100 is more preferably in a range of 10 to 50% of the thickness of the first resin layer 22. The size of the slits 23 in the directions perpendicular to the stacking direction of the solar cell module 100 (in the x-axis and y-axis directions) is not particularly limited, and may be determined in view of the elimination of bubbles and the strength of the first resin layer 22.

The direction of the slits 23 in the stacking direction of the solar cell module 100 is preferably parallel to the stacking direction of the solar cell module 100. The slits 23 having such a direction hardly cause reflection or refraction of light since the incident direction of light and the direction of the slits 23 is parallel to each other. The slits 23 having such a direction thus can suppress a loss of light. The direction of the slits 23 in the directions perpendicular to the stacking direction of the solar cell module 100 (in the x-axis and y-axis directions) is not particularly limited, and may be varied as appropriate depending on purposes.

A distance between the slits 23 in the cross-sectional view parallel to the stacking direction of the solar cell module 100 is preferably in a range of 0.1 mm to 10 mm, more preferably in a range of 0.5 mm to 2 mm, particularly preferably in a range of 0.8 mm to 1.2 mm. The distance between the slits 23 in such a range can improve the elimination of bubbles and keep the strength of the first resin layer 22.

As described above, in the solar cell module 100 according to the present embodiment, the first resin layer 22 may include gel, and the first resin layer 22 may be provided with the slits 23. Accordingly, obstruction to sunlight or a defect in external appearance of the solar cell module 100 caused by bubbles in the solar cell module 100 can be avoided.

(Embodiment 6)

Embodiment 6 is described below. Embodiment 6 relates to a solar cell module including a plurality of solar cells, as in the case of Embodiment 1. The solar cell module preferably can keep good external appearance. While the solar cell module according to Embodiment 6 has the configuration similar to the case described above, the solar cell module has a difference in refractive index between the first resin layer 22 and the resin layer adjacent to the first resin layer 22 which is set in a predetermined range. The points different from the case described above will mainly be described below.

The solar cell module 100 according to the present embodiment, a difference in refractive index between the first resin layer 22 and the resin layer adjacent to the first resin layer 22 is preferably 0.1 or smaller. More particularly, the difference in refractive index between the first resin layer 22 and the resin layer adjacent to the first resin layer 22 on the opposite side of the first resin substrate 20 is preferably 0.1 or smaller. For example, the difference in refractive index between the first resin layer 22 and the second resin layer 24 is preferably 0.1 or smaller. The difference in refractive index set to such a range improves the external appearance of the solar cell module 100. In particular, a circular pattern of light is hardly recognized when the solar cell module 100 with the difference in refractive index described above is viewed from above. The difference in refractive index between the first resin layer 22 and the resin layer adjacent to the first resin layer 22 is more preferably 0.05 or smaller.

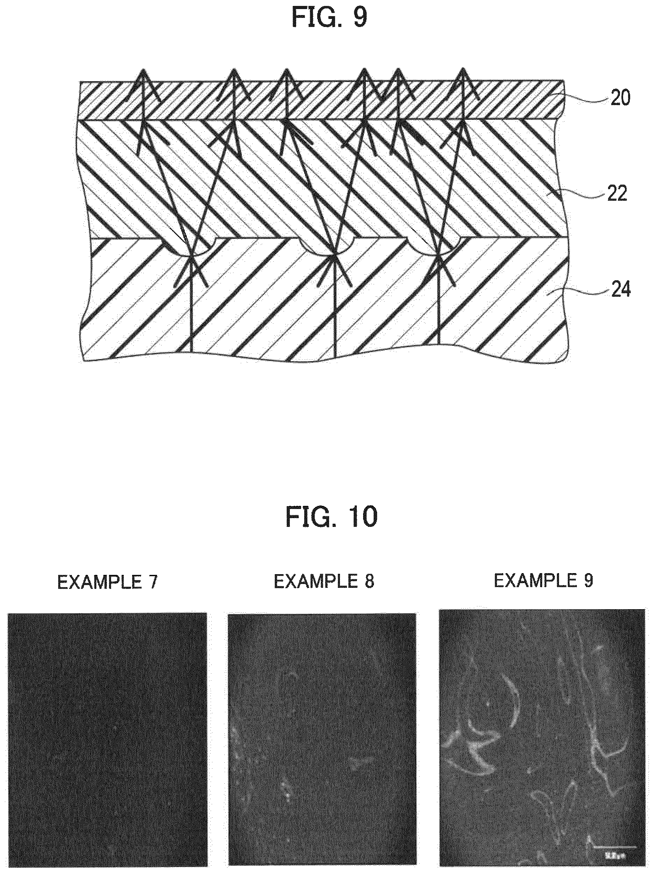

The circular pattern of light may be generated because of the following reasons. As described above, since the tensile modulus of elasticity of the first resin layer 22 is smaller than the tensile modulus of elasticity of the second resin layer 24, the resistance to impact in the solar cell module 100 can be improved. However, the first resin layer 22 tends to be deformed to cause corrugations when the solar cell module 100 is laminated while being heated, since the first resin layer 22 is more flexible than the second resin layer 24. The first resin layer 22 tends to cause corrugations particularly when the solar cell module 100 is laminated in a vacuum. When such corrugations are caused, light is refracted at the interface between the first resin layer 22 and the resin layer adjacent to the first resin layer 22, as indicated by the arrows in FIG. 9. The refraction of the light seems to cause the circular pattern to influence the external appearance of the solar cell module 100.

The external appearance of the solar cell module 100 when the difference in refractive index between the first resin layer 22 and the resin layer adjacent to the first resin layer 22 is set to 0.1 or smaller was evaluated in the following examples. It should be understood that the present embodiment is not intended to be limited to the following examples.

[Example 7]

A first resin substrate having a thickness of 1 mm, a first resin layer having a thickness of 1 mm, a second resin layer having a thickness of 0.6 mm, photoelectric converters, a third resin layer having a thickness of 0.6 mm, and a second resin substrate having a thickness of 2 mm were sequentially stacked from above, and compressed and heated at 145 °C under reduced pressure, so as to prepare a solar cell module. The material used for the first resin substrate was polycarbonate (PC). The material used for the first resin layer was acrylic gel having a refractive index in a range of 1.49 to 1.53. The material used for the second resin layer was an ethylene-vinyl acetate copolymer (EVA) having a refractive index of 1.54. The photoelectric converters used were solar cells. The material used for the third resin layer was an ethylene-vinyl acetate copolymer (EVA). The material used for the second resin substrate was carbon-fiber reinforced plastic (CFRP). The difference in refractive index between the first resin layer and the second resin layer was in a range of 0.01 to 0.05.

[Example 8]

A solar cell module was prepared in the same manner as in Example 7 except that the acrylic gel used for the first resin layer was changed to silicone gel having a refractive index of 1.43, and that a fifth resin layer was additionally provided between the first resin layer and the second resin layer. The fifth resin layer includes acrylic resin having a refractive index in a range of 1.49 to 1.53. The difference in refractive index between the first resin layer and the fifth resin layer was in a range of 0.06 to 0.10.

[Example 9]

A solar cell module was prepared in the same manner as in Example 7 except that the acrylic gel used for the first resin layer was changed to silicone gel having a refractive index of 1.43. The difference in refractive index between the first resin layer and the second resin layer was 0.11.

[Example 10]

A solar cell module was prepared in the same manner as in Example 8 except that the acrylic resin used for the fifth resin layer was changed to polyethylene terephthalate (PET) having a refractive index of 1.60. The difference in refractive index between the first resin layer and the fifth resin layer was 0.17.

[Example 11]

A solar cell module was prepared in the same manner as in Example 8 except that the acrylic resin used for the fifth resin layer was changed to polyvinylidene chloride (PVDC) having a refractive index in a range of 1.60 to 1.63. The difference in refractive index between the first resin layer and the fifth resin layer was in a range of 0.17 to 0.20.

[Comparative Example 8]

A solar cell module was prepared in the same manner as in Example 9 except that the polycarbonate (PC) used for the first resin substrate was changed to glass. The difference in refractive index between the first resin layer and the second resin layer was 0.11.

[Comparative Example 9]

A solar cell module was prepared in the same manner as in Example 9 except that the ethylene-vinyl acetate copolymer (EVA) of the second resin layer was not provided.

[Evaluation]

The external appearance of the solar cell module obtained in each example was evaluated visually. Table 4 shows the evaluation results. FIG. 10 shows the external appearance of the respective solar cell modules obtained in Examples 7 to 9 for reference.

[Table 4]

|  | Substrate | First Resin Layer | Fifth Resin Layer | Second Resin Layer | Difference in Refractive Index | External Appearance |
|---|---|---|---|---|---|---|
| Example 7 | PC | Acrylic Gel | - | EVA | 0.01 to 0.05 | Good |
| Example 8 | PC | Silicone Gel | Acrylic Resin | EVA | 0.06 to 0.10 | Satisfactory |
| Example 9 | PC | Silicone Gel | - | EVA | 0.11 | Circular Pattern |
| Example 10 | PC | Silicone Gel | PET | EVA | 0.17 | Circular Pattern |
| Example 11 | PC | Silicone Gel | PVDC | EVA | 0.17 to 0.20 | Circular Pattern |
| Comparative Example 8 | Glass | Silicone Gel | - | EVA | 0.11 | Good |
| Comparative Example 9 | PC | Silicone Gel | - | - | - | Good |

As shown in FIG. 10, a circular pattern of light was not recognized in appearance in the solar cell module in Example 7. This may be because the difference in refractive index between the first resin layer and the second resin layer is 0.05 or smaller. As shown in FIG. 10, a circular pattern of light was hardly recognized in appearance in the solar cell module in Example 8. This may be because the difference in refractive index between the first resin layer and the fifth resin layer is 0.1 or smaller.

As shown in FIG. 10, a circular pattern of light was recognized in the solar cell module in Example 9. This may be because the difference in refractive index between the first resin layer and the second resin layer exceeds 0.1. A circular pattern of light was recognized also in the solar cell modules in Examples 10 and 11. This may be because the difference in refractive index between the first resin layer and the fifth resin layer exceeds 0.1.

A circular pattern of light was not recognized in the solar cell module in Comparative Example 8, although the difference in refractive index between the first resin layer and the second resin layer exceeds 0.1. This may be because the substrate is formed of glass and therefore was not deformed upon lamination to suppress deformation of the first resin layer and the second resin layer, in contrast to the case of the resin substrate. However, the solar cell module in Comparative Example 8 increases the weight because of the glass used.

A circular pattern of light was not recognized in appearance in the solar cell module in Comparative Example 9. This may be because the first resin layer is in direct contact with the photoelectric converters, and therefore, the light was not refracted at the interface therebetween. However, the solar cell module in Comparative Example 9 does not have sufficient resistance to impact, since the solar cell module does not include the second resin layer for dispersing a load applied to the first resin layer.

As described above, the solar cell module 100 according to the present embodiment, the difference in refractive index between the first resin layer 22 and the resin layer adjacent to the first resin layer 22 is 0.1 or smaller. Accordingly, the external appearance of the solar cell module 100 can be improved.

(Embodiment 7)

Embodiment 7 is described below. Embodiment 7 relates to a solar cell module including a plurality of solar cells, as in the case of Embodiment 1. The solar cell module preferably suppresses a change in color caused in resin used for a long period of time. While the solar cell module according to Embodiment 7 has the configuration similar to the case described above, the solar cell module further includes an oxygen barrier layer. The points different from the case described above will mainly be described below.

The solar cell module 100 according to the present embodiment preferably further includes an oxygen barrier layer 70 provided under the second resin layer 24 and over the third resin layer 26 and having oxygen transmission rate of 200 $cm^3/m^2 \cdot 24h \cdot atm$ or lower. The oxygen barrier layer 70 having such properties can decrease the amount of oxygen entering the solar cell module 100, and decrease the amount of a radical derived from oxygen generated in the second resin layer 24 and the third resin layer 26. Accordingly, decomposition of the resin caused by the radical can be suppressed, so as to avoid a change in color in the resin.

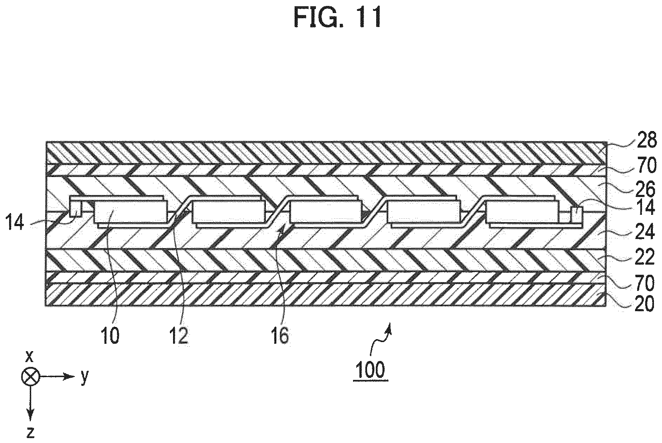

In the present embodiment, the oxygen barrier layer 70 may be provided under the second resin layer 24. In particular, the oxygen barrier layer 70 may be provided between the second resin layer 24 and the first resin layer 22. The oxygen barrier layer 70 may be in direct contact with the second resin layer 24, or is not necessarily in contact with the second resin layer 24. For example, the oxygen barrier layer 70 may be provided between the first resin layer 22 and the first resin substrate 20, as illustrated in the embodiment shown in FIG. 11. Alternatively, the oxygen barrier layer 70 may be provided under the first resin substrate 20. In addition to the oxygen barrier layer 70 or instead of the oxygen barrier layer 70, at least one of the first resin substrate 20 and the first resin layer 22 may have oxygen transmission rate of 200 $cm^3/m^2 \cdot 24h \cdot atm$ or lower.

In the present embodiment, the oxygen barrier layer 70 may be provided over the third resin layer 26. For example, the oxygen barrier layer 70 may be provided between the third resin layer 26 and the second resin substrate 28, as illustrated in the embodiment shown in FIG. 11. The oxygen barrier layer 70 may be in direct contact with the third resin layer 26 as illustrated in the embodiment shown in FIG. 11, or is not necessarily in contact with the third resin layer 26. For example, the oxygen barrier layer 70 may be provided over the second resin substrate 28. In addition to the oxygen barrier layer 70 or instead of the oxygen barrier layer 70, the second resin substrate 28 may have oxygen transmission rate of 200 $cm^3/m^2 \cdot 24h \cdot atm$ or lower.

The oxygen transmission rate of the oxygen barrier layer 70 is preferably 200 $cm^3/m^2 \cdot 24h \cdot atm$ or lower, more preferably in a range of 0.001 to 200 $cm^3/m^2 \cdot 24h \cdot atm$. The oxygen transmission rate in such a range can suppress a change in color in the resin included in the solar cell module 100. The oxygen transmission rate may be measured in accordance with the provision of JIS K7126-2 (Plastics-Film and sheeting-Determination of gas-transmission rate-Part 2: Equal-pressure method). The oxygen transmission rate may be measured under the conditions of a temperature of 23 °C and humidity of 90% RH.

Examples of materials used for the oxygen barrier layer 70 include polyvinyl chloride (PVC), polyethylene terephthalate (PET), cast nylon (CNY), biaxially oriented nylon (ONY), polyvinylidene chloride (PVDC) coated biaxially oriented polypropylene (OPP), polyvinylidene chloride (PVDC) coated biaxially oriented nylon (ONY), poly(meta-xylylene adipamide) (nylon MX-D6), ethylene-vinylalcohol copolymer (EVOH), vinylidene chloride-methyl acrylate copolymer, alumina coated PET, silica coated PET, and nano-composite coated PET.

As described above, the solar cell module 100 according to the present embodiment may further include the oxygen barrier layer 70 provided under the second resin layer 24 and over the third resin layer 26 and having oxygen transmission rate of 200 cm$^3$/m$^2$·24h·atm or lower. Accordingly, decomposition of the resin caused by a radical derived from oxygen can be suppressed, so as to avoid a change in color in the resin.

The entire content of Japanese Patent Application No. P2015-240766 (filed on December 10, 2015) is herein incorporated by reference.

While the present invention has been described above by reference to the examples, the embodiments are not intended to be limited to the descriptions thereof, and it will be apparent to those skilled in the art that various modifications and improvements can be made.

INDUSTRIAL APPLICABILITY

The solar cell module described in the embodiments has the tensile modulus of elasticity of the first resin layer which is smaller than the tensile modulus of elasticity of each of the resin substrate, the second resin layer, and the third resin layer. Accordingly, the embodiments can improve the resistance to impact in the solar cell module.

REFERENCE SIGNS LIST

| | |
|---|---|
| 10 | SOLAR CELL (PHOTOELECTRIC CONVERTER) |
| 12 | TAB LEAD |
| 14 | CONNECTING LEAD |
| 16 | SOLAR CELL STRING (PHOTOELECTRIC CONVERTER) |
| 20 | FIRST RESIN SUBSTRATE (RESIN SUBSTRATE) |
| 22 | FIRST RESIN LAYER |
| 23 | SLIT |
| 24 | SECOND RESIN LAYER |
| 26 | THIRD RESIN LAYER |
| 28 | SECOND RESIN SUBSTRATE (ANOTHER RESIN SUBSTRATE) |
| 40 | FOURTH RESIN LAYER |
| 50 | LOW THERMAL EXPANSION LAYER |
| 60 | LUBRICANT LAYER |
| 70 | OXYGEN BARRIER LAYER |
| 100 | SOLAR CELL MODULE |

**Claims**

1. A solar cell module comprising:

   a resin substrate;
   a first resin layer provided over the resin substrate;
   a second resin layer provided over the first resin layer;
   a photoelectric converter provided over the second resin layer; and
   a third resin layer provided over the photoelectric converter and the second resin layer,
   wherein a tensile modulus of elasticity of the first resin layer is smaller than a tensile modulus of elasticity of each of the resin substrate, the second resin layer, and the third resin layer.

2. The solar cell module according to claim 1, wherein water vapor transmission rate of the second resin layer is smaller than water vapor transmission rate of the first resin layer.

3. The solar cell module according to claim 1 or 2, wherein:

   the photoelectric converter is formed into a plate-like shape having a light receiving surface and a rear surface;
   the light receiving surface of the photoelectric converter is arranged in contact with the second resin layer; and
   the rear surface of the photoelectric converter is arranged in contact with the third resin layer.

4. The solar cell module according to claim 3, wherein the photoelectric converter is sealed between the second resin layer and the third resin layer.

**5.** The solar cell module according to any one of claims 1 to 4, wherein the second resin layer and the third resin layer include an identical material.

**6.** The solar cell module according to any one of claims 1 to 4, wherein:

the second resin layer and the third resin layer include different materials; and
the tensile modulus of elasticity of the third resin layer is smaller than the tensile modulus of elasticity of the second resin layer.

**7.** The solar cell module according to any one of claims 1 to 6, further comprising another resin substrate provided over the third resin layer.

**8.** The solar cell module according to claim 7, wherein a tensile modulus of elasticity of the other resin substrate is greater than the tensile modulus of elasticity of the resin substrate.

**9.** The solar cell module according to claim 7 or 8, further comprising a fourth resin layer provided between the other resin substrate and the third resin layer,
wherein a tensile modulus of elasticity of the fourth resin layer is smaller than the tensile modulus of elasticity of each of the resin substrate, the second resin layer, the third resin layer, and the other resin substrate.

**10.** The solar cell module according to any one of claims 7 to 9, wherein flexural rigidity of the other resin substrate is greater than flexural rigidity of the resin substrate.

**11.** The solar cell module according to any one of claims 1 to 10, further comprising a low thermal expansion layer provided over the third resin layer and having a smaller coefficient of thermal expansion than the resin substrate.

**12.** The solar cell module according to any one of claims 1 to 11, wherein:

the first resin layer includes gel; and
the first resin layer is provided with slits.

**13.** The solar cell module according to any one of claims 1 to 12, further comprising a lubricant layer provided between the resin substrate and the first resin layer,
wherein a coefficient of static friction between the resin substrate and the first resin layer is in a range of 0.0001 to 0.1.

**14.** The solar cell module according to any one of claims 1 to 13, wherein a difference in refractive index between the first resin layer and a resin layer adjacent to the first resin layer is 0.1 or smaller.

**15.** The solar cell module according to any one of claims 1 to 14, further comprising an oxygen barrier layer provided under the second resin layer and over the third resin layer and having oxygen transmission rate of 200 $cm^3/m^2 \cdot 24h \cdot atm$ or lower.

**16.** The solar cell module according to any one of claims 1 to 15, wherein:

adjacent photoelectric converters are electrically connected to each other with a tab lead; and
the tab lead includes aluminum.

# FIG. 1

# FIG. 2

# FIG. 3

# FIG. 4

(a)

•~P

20
22
24
26
28

30

10

**100**

z
y ←⊗ x

(b)

•~P

220
222
224
226
228

230

210

**200**

# FIG. 5

28
40
26
14
24
22
20

14

10 12 16

**100**

x
⊗ → y
z

## FIG. 6

## FIG. 7

# FIG. 8

# FIG. 9

# FIG. 10

| EXAMPLE 7 | EXAMPLE 8 | EXAMPLE 9 |

FIG. 11

**EP 3 389 098 A1**

# INTERNATIONAL SEARCH REPORT

| International application No. |
|---|
| PCT/JP2016/005086 |

**A. CLASSIFICATION OF SUBJECT MATTER**
*H01L31/048(2014.01)i*

According to International Patent Classification (IPC) or to both national classification and IPC

**B. FIELDS SEARCHED**

Minimum documentation searched (classification system followed by classification symbols)
H01L31/048-31/049

Documentation searched other than minimum documentation to the extent that such documents are included in the fields searched
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2011-49485 A (Kyocera Corp.), 10 March 2011 (10.03.2011), entire text (Family: none) | 1-16 |
| Y | WO 2011/093383 A1 (Sanyo Electric Co., Ltd.), 04 August 2011 (04.08.2011), entire text & JP 2011-159711 A & US 2012/0285536 A1 & EP 2530737 A1 | 1-16 |
| Y | JP 2005-44911 A (Kyocera Corp.), 17 February 2005 (17.02.2005), entire text (Family: none) | 6 |

| ☒ Further documents are listed in the continuation of Box C. | ☐ See patent family annex. |
|---|---|

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 February 2017 (03.02.17) | 21 February 2017 (21.02.17) |

| Name and mailing address of the ISA/ | Authorized officer |
|---|---|
| Japan Patent Office 3-4-3,Kasumigaseki,Chiyoda-ku, Tokyo 100-8915,Japan | |
| | Telephone No. |

Form PCT/ISA/210 (second sheet) (January 2015)

**INTERNATIONAL SEARCH REPORT**

International application No.

PCT/JP2016/005086

C (Continuation).    DOCUMENTS CONSIDERED TO BE RELEVANT

| Category* | Citation of document, with indication, where appropriate, of the relevant passages | Relevant to claim No. |
|---|---|---|
| Y | WO 2009/091068 A1  (Affinity Co., Ltd.), 23 July 2009 (23.07.2009), entire text & EP 2234172 A1          & US 2010/0275992 A1 & JP 2011-254116 A       & CN 101960614 B & US 2013/0178009 A1 | 7-8,10 |
| Y | JP 2010-512027 A  (E.I. Du Pont de Nemours & Co.), 15 April 2010 (15.04.2010), entire text & US 2008/0128018 A1     & WO 2008/070078 A1 & EP 2097931 A1          & KR 10-2009-0096487 A & CN 101542746 A         & US 2010/0065109 A1 | 9,11,13,15 |
| Y | JP 2006-134969 A  (Mitsui Chemicals Fabro Inc.), 25 May 2006 (25.05.2006), entire text (Family: none) | 12 |
| E,X E,Y | JP 6057113 B1  (Panasonic Intellectual Property Management Co., Ltd.), 11 January 2017 (11.01.2017), entire text (Family: none) | 1-10,14,16 11-13,15 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011049485 A
- JP P2015240766 B